# EUROPEAN PATENT SPECIFICATION

(11) **EP 3 340 753 B1**
(45) Date of publication and mention of the grant of the patent: **30.04.2025**
(21) Application number: 16206325.9
(22) Date of filing: 22.12.2016
(51) Int. Cl.: H05K 1/18, H05K 3/46, H01R 12/73

(54) **METHOD OF INTEGRATING A CONNECTOR MEMBER WITH COMPONENT CARRIER**
VERFAHREN EINEN VERBINDER IN KOMPONENTENTRÄGER ZU INTEGRIEREN
PROCÉDÉ DE INTÉGRER UN ÉLÉMENT DE CONNECTEUR DANS UN SUPPORT DE COMPOSANT

(43) Date of publication of application: 27.06.2018
(60) Divisional application: 25153279.2
(73) Proprietor: AT & S Austria Technologie & Systemtechnik Aktiengesellschaft, 8700 Leoben (AT)
(72) Inventor: Tuominen, Mikael, Shanghai (CN); Vockenberger, Christian, 8700 Leoben (AT)
(74) Representative: Dilg, Haeusler, Schindelmann Patentanwaltsgesellschaft mbH

(56) References cited:
- WO-A1-2012/053728
- WO-A2-2014/131071
- US-A1- 2012 160 803
- US-A1- 2015 194 753

## Description

The invention relates to a method of manufacturing a component carrier.

Connector members may be integrated with printed circuit boards (PCB). However, a corresponding manufacture is challenging. Furthermore, PCBs with connector member may suffer from reliability issues.

WO 2014/131071 A2 discloses a semi-finished product for the production of a printed circuit board with alternating electrically conductive and electrically insulating layers. An electronic component is mounted via an anisotropic film onto one of the electrically layers. Then, the electronic component is embedded in an electrically insulating layer of prepreg and the semi-finished product is further processed. The insulating layer, which embeds the component, comprises hereby a clearance into which the electronic component may be arranged.

US 2012/0160803 A1 discloses a method for manufacturing a multilayer printed circuit board. Hereby, no liquid should remain in the cavity which is for accommodating the electronic component. The circuit board comprises alternating electrically conductive and electrically insulating layers, wherein the cavity is located below one of the electrically insulating layers.

WO 2012/053728 A1 discloses a printed circuit board comprising a cavity for placing an electronic component. The circuit board comprises alternating electrically conductive and electrically insulating layers. In order to facilitate the access to an embedded circuit pattern, it is proposed to perform two laser drillings down to the embedded circuit pattern. Due to the very low adhesion strength of a cavity separation layer, the layers above the circuit pattern can be removed in a feasible manner. Finally, the circuit pattern in the cavity is exposed and can be connected to an active or passive device.

US 2015/194753 A1 discloses mid-plane board-to-board connectors for connection two circuit boards, wherein the connectors require reduced space (low height). Hereby, the lower connector is at least partially arranged in a recess of the respective circuit board.

It is an object of the invention to enable integration of a connector member with a component carrier with high reliability and a simple manufacturing process.

In order to achieve the object defined above, a component carrier, a semifinished product, a connector arrangement and methods of manufacturing a component carrier according to the independent claims are provided.

According to an exemplary embodiment of the invention, a method of manufacturing a component carrier is provided, wherein the method comprises
i) mounting a connector member on a substantially planar layer structure;
ii) interconnecting a further layer structure with the layer structure,
   wherein, after the mounting, the further layer structure, which is provided with a recess, is attached on the layer structure with the connector member being at least partially located within the recess;
iii) after the interconnecting, exposing at least part of the connector member by removing material of at least one of the layer structures;
   Hereby, after the interconnecting and the exposing, at least a portion of the connector member remains sunk within the further layer structure.

According to an example to provide a better understanding of the invention, a method of manufacturing a component carrier is provided, wherein the method comprises at least partially surrounding a connector member by a plurality of electrically insulating layer structures comprising a polymer (in particular a resin or another dielectric material), and, during the surrounding, inhibiting a flow of polymer into an interior of the connector member.

According to an example to provide a better understanding of the invention, a semifinished product obtainable during manufacturing a component carrier is provided, wherein the semifinished product comprises a connector member, and a plurality of layer structures surrounding the connector member so that the connector member is accommodated in a void volume within the layer structures.

According to an example to provide a better understanding of the invention, a component carrier is provided which comprises a plurality of layer structures, at least one of which comprising low-flow resin or no-flow resin, and a connector member on and/or surrounded by the layer structure, wherein an interior of the connector member is free of the low-flow resin or no-flow resin.

According to an example to provide a better understanding of the invention, a connection arrangement is provided which comprises a component carrier having the above-mentioned features, and an electronic device comprising a counter connector member configured for establishing a plug connection with the connector member.

According to an example to provide a better understanding of the invention, a component carrier is provided which comprises a plurality of laminated layer structures defining a recess (which may be delimited along at least part of its circumference by a side wall, but which may for instance also be open at a lateral side), in particular a cavity (which may be delimited along its entire circumference by a side wall), and a connector member at least partially in the recess and on and/or at least partially surrounded by the layer structures.In the context of the present application, the term "layer structure" may particularly denote one or more full or continuous layers, one or more patterned layers, and/or a plurality of islands-type separate elements formed together within a plane.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "low-flow material" (sometimes also denoted as "no-flow material") may particularly denote material which has no or only a very limited tendency to flow during processing under external pressure and elevated temperature, in particular during lamination. In particular, low-flow material may have a sufficiently high viscosity, for instance at least 5000 Poise, preferably at least 10000 Poise, at lamination temperature (for instance 150°C). For example, when ordinary prepreg is heated under pressure, its resin melts (liquefies) and freely flows in any voids in the environment. There is a certain period of time during which the resin of ordinary prepreg remains fluidic enough to flow freely. In contrast to this, low-flow material as implemented in accordance with exemplary embodiments of the invention is specifically configured to suppress or even eliminate flow during lamination, so that the low-flow material substantially rests in place during lamination. However, the "low-flow material" or "no-flow material" may still be at least partially uncured when being provided prior to lamination.

In the context of the present application, the term "semifinished product" may particularly denote a physical structure which is not yet readily manufactured but requires further processing to obtain a final product which can functionally serve as stand-alone component carrier. In other words, a semifinished product may be a pre-form of a component carrier to be manufactured based on the semifinished product.

According to an exemplary embodiment of the invention, a connector member is integrated with electrically insulating and/or electrically conductive layer structures of a component carrier by firstly mounting the connector member on such a layer structure, by subsequently laminating a further layer structure onto the previously mentioned layer structure including surface mounted connector member, and by thereafter exposing the connector member with regard to an environment of the component carrier by removing a portion of the material of one or both of the layer structures. By taking this measure, it is dispensable to mount the connector member in a preformed cavity of a layer structure by soldering, which is conventionally a difficult task. In contrast to this, an exemplary embodiment of the invention does not put any limitation on the topology of a surface of the layer structure on which the connector member is to be mounted. Highly advantageously, flow of resin or the like into the connector member during lamination of the further layer structure onto the layer structure plus connector member may be safely prevented. This can be achieved by the use of an already fully cured material for at least one of the layer structures, the use of low-flow or no-flow resin for at least one of the layer structures, and/or the use of one or more precut layer structures for accommodating the connector member in a corresponding recess. By taking one or more of these or other appropriate measures, the connector member may be protected against undesired flow of resin during lamination into contact structures of the connector member, which might deteriorate or even damage its connection function. According to an exemplary embodiment, a cavity for accommodating the connector member can be formed advantageously during or after having mounted the connector member on a layer structure, i.e. by an additive process. By locating or sinking at least part of the connector member in such a cavity formed after mounting the connector member, a highly stable, properly protected and compact component carrier with integrated connector function may be manufactured.

In the following, further exemplary embodiments of the method will be explained.

In an embodiment, at least one of the layer structures comprises at least one of the group consisting of at least one electrically insulating layer structure and/or at least one electrically conductive layer structure. Thus, the connector member may be mounted on or within a dielectric and/or a metallic material of a stack below and/or above the connector member.

In an embodiment, the interconnecting comprises laminating the further layer structure with the connector member and the layer structure. Lamination may be accomplished by the application of mechanical pressure, if desired or required in combination with heat.

In an embodiment, the connector member is mounted on or electrically coupled to the layer structure by at least one of the group consisting of forming a copper connection, soldering and gluing, in particular using at least one of an Anisotropic Conductive Film (ACF), and an Anisotropic Conductive Paste (ACP). An ACF is an adhesive interconnect system in the shape of a film that may be used to establish electrical and mechanical connections. ACF can be used alternatively in a paste form referred to as ACP. By taking this measure, it is possible to design a reliable electric interconnection between the connector member and the layer structure (which may be an electrically insulating structure which may have one or more electrically conductive elements embedded therein, also denoted as electrically conductive layer structure) without the need to involve high temperature processes. When the material of the layer structures is compatible with solder temperatures, a solder connection can be established as well.

In an embodiment, exposing the connector member comprises forming a cavity in at least one of the layer structures. Advantageously, cavity formation may hence be carried out after having mounted to the connector member so that a cumbersome mounting process of the connector member in a preformed cavity can be omitted. Mounting of the connector member in a preformed cavity is conventionally particularly critical when the connection to be made is a solder connection.

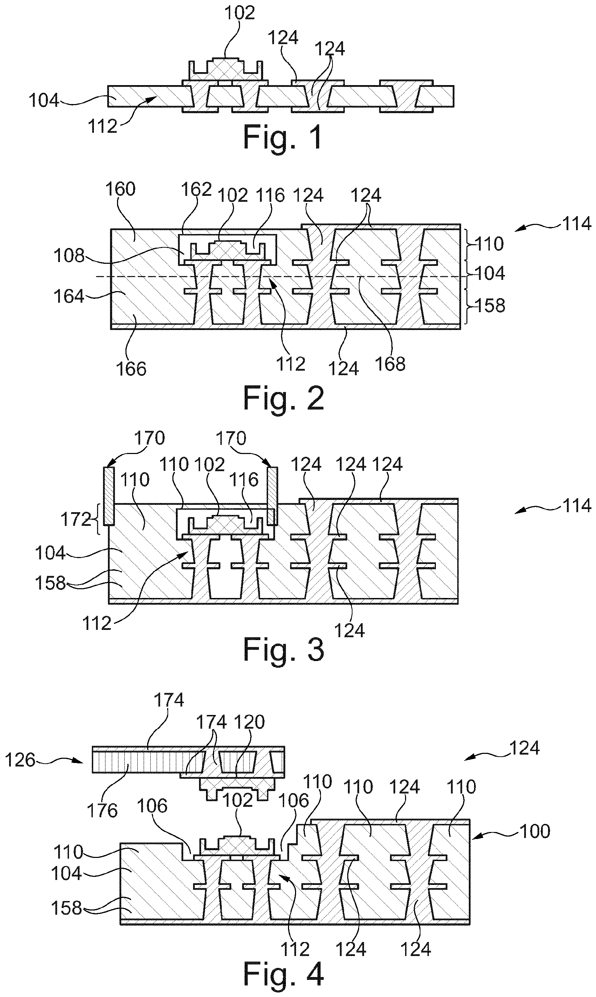

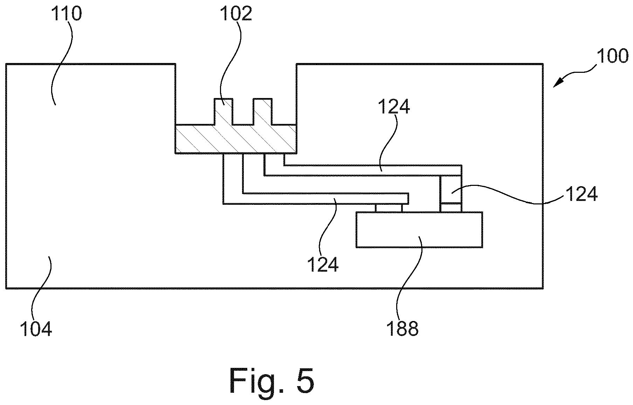

After the interconnecting and the exposing, at least a portion of the connector member remains sunk within at least one of the layer structure and of the further layer structure. Thus, the connector member may be retracted within the cavity with regard to an exterior surface of the component carrier so that the connector member can be mechanically protected with regard to a mechanical impact from the environment. Moreover, this results in a compact design of the component carrier. The term "sinking" of the connector member shall cover both a hidden or retracted location of the connector member in the cavity (as for example in Figure 4), but also an at least partial embedding of the connector member (also of lateral surfaces thereof) within one or more of the layer structures (as for example in Figure 5).

The connector member is mounted on a substantially planar layer (rather than within a cavity) of the layer structure. This simplifies the mounting procedure.

After the mounting, the further layer structure, which is provided with a recess, is attached on the layer structure with the connector member being at least partially located within the recess. Recessing the further layer structure may allow to keep (in particular dielectric) material of the further layer structure sufficiently far away from the connector member so that, during lamination, there is no risk that material of the further layer structure flows into tiny connection structures of the connector member.

In an embodiment, the further layer structure is attached to (fully or partially) cover the connector member (for instance to hermetically encapsulate the connector member). In particular, even the top of the connector member may be temporarily covered (with or without contact) by (in particular electrically insulating) material prior to the removal, and as a result of the lamination.

In an embodiment, the removing comprises laser cutting. This allows to precisely define a cap portion which can be removed from the rest of the component carrier to be manufactured. However, alternatively, also material removal by a mechanical procedure is possible, for instance by mechanically drilling, routing etc. This allows to precisely define size and position of the cavity in which the connector member is mounted. Hence, a combination of an additive process (i.e. the lamination of the further layer structure) with a subtractive process (i.e. the material removal) may be carried out.

In an example to provide a better understanding of the invention, the flow of polymer (in particular resin) into the connector member is inhibited by configuring at least a part of the plurality of (in particular electrically insulating) layer structures from low-flow prepreg or no-flow prepreg. The polymer or resin of such prepreg material has only a very limited or even no tendency of flowing into a surrounding during lamination. This material selection protects the connector member against contamination.

In an example to provide a better understanding of the invention, the connector member is mounted on a core, in particular on a fully cured core. In the context of the present application, the term "core" may particularly denote already cured electrically insulating material providing a stable base for one or more electronic components. A core may be made of cured resin (such as epoxy resin) with fibers (such as glass fibers) embedded therein, for example FR4. In particular, such a core may be made of a thickness being higher than that of a single layer (such as a prepreg layer) as used in PCB technology. In the context of the present application, the term "fully cured" may particularly denote a material property according to which the corresponding material (such as resin) is not capable any more of being re-melted to become flowable and of being subsequently re-solidified for interconnecting various elements of the manufactured component carrier. In particular, resin material of the fully cured core may be already cross-linked. Thus, the fully cured core material may be C-stage material rather than A-stage or B-stage material.

In an example to provide a better understanding of the invention, during the surrounding, a flow of polymer or resin into a functional connector structure of the connector member is prevented. This can be accomplished by one or more of the following measures: using precut electrically insulating or electrically conductive layers in particular of the further layer structure for spacing the mounted connector member with regard to surrounding dielectric material; using no-flow prepreg or low-flow prepreg for any of the layer structures for suppressing resin flow during lamination (in particular for a layer structure located next to the connector member); using fully cured dielectric material (in particular a core) for any of the layer structures for disabling resin flow during lamination.

In an embodiment, the connector member is a female connector member (i.e. having an indentation to be filled by a protrusion of a male connector member) configured for cooperating with a male connector member (i.e. having the protrusion for filling the indentation of the female connector member). Alternatively, the connector member may be also a male connector member configured for cooperating with a female connector member.

In an embodiment, the connector member is configured for establishing an electric connection with a counter connector member. Thus, the connection function may not only establish a mechanical connection (by a form closure, by friction connection, or the like), but may also simultaneously establish an electric connection (in particular by the coupling of one or more electric contacts of the connector member with one or more electric contacts of the counter connector member). In particular, one or more electric contacts of the connector member may be electrically coupled with the electrically conductive layer structure of the component carrier. The one or more electric contacts of the counter connector member may be also electrically coupled with an electrically conductive layer structure of the electronic device.

In an embodiment, the component carrier comprises at least one electronic component embedded in at least one of the layer structure and the further layer structure. Advantageously, the layer structures may be synergistically used also for embedding a component which increases the level of functionality of the component carrier.

In an embodiment, the component is electrically coupled with the connector member. This can be accomplished with low effort by the electrically conductive layer structure of the component carrier.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element or a ferrimagnetic element, for instance a ferrite core) or may be a paramagnetic element. However, the component may also be a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure, if desired supported by thermal energy. The mentioned stack may provide a plate-shaped component carrier capable of providing a large mounting surface for further components and being nevertheless very thin and compact. The term "layer structure" may particularly denote a continuous layer, a patterned layer or a plurality of non-consecutive islands within a common plane.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, and a substrate (in particular an IC substrate).

In the context of the present application, the term "printed circuit board" (PCB) may particularly denote a component carrier (which may be plate-shaped (i.e. planar), three-dimensionally curved (for instance when manufactured using 3D printing) or which may have any other shape) which is formed by laminating several electrically conductive layer structures with several electrically insulating layer structures, for instance by applying pressure, if desired accompanied by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier having substantially the same size as a component (in particular an electronic component) to be mounted thereon. More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing spheres (such as glass spheres).

In an embodiment, the at least one electrically insulating layer structure comprises at least one of the group consisting of resin (such as reinforced or non-reinforced resins, for instance epoxy resin or Bismaleimide-Triazine resin, more specifically FR-4 or FR-5), cyanate ester, polyphenylene derivate, glass (in particular glass fibers, multi-layer glass, glass-like materials), prepreg material, polyimide, polyamide, liquid crystal polymer (LCP), epoxy-based Build-Up Film, polytetrafluoroethylene (Teflon), a ceramic, and a metal oxide. Reinforcing materials such as webs, fibers or spheres, for example made of glass (multilayer glass) may be used as well. Although prepreg or FR4 are usually preferred, other materials may be used as well. For high frequency applications, high-frequency materials such as polytetrafluoroethylene, liquid crystal polymer and/or cyanate ester resins may be implemented in the component carrier as electrically insulating layer structure.

In an embodiment, the at least one electrically conductive layer structure comprises at least one of the group consisting of copper, aluminum, nickel, silver, gold, palladium, and tungsten. Although copper is usually preferred, other materials or coated versions thereof are possible as well, in particular coated with supra-conductive material such as graphene.

In an embodiment, the component carrier is a laminate-type component carrier. In such an embodiment, the component carrier is a compound of multiple layer structures which are stacked and connected together by applying a pressing force, if desired accompanied by heat.

The aspects defined above and further aspects of the invention are apparent from the examples of embodiment to be described hereinafter and are explained with reference to these examples of embodiment.

Figure 1 to Figure 4 illustrate different cross-sectional views of structures obtained during carrying out a method of manufacturing a component carrier according to an exemplary embodiment of the invention.

Figure 5 illustrates a cross-sectional view of a component carrier according to another exemplary embodiment of the invention.

The illustrations in the drawings are schematical. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment of the invention, an embedded connector member is provided which is integrated in a component carrier.

Conventionally, it has not been possible to embed a connector part inside of a component carrier such as a printed circuit board (PCB). One reason for this is that during the PCB lamination process, the epoxy resin may conventionally flow into and/or between the connector constructions and may deteriorate or damage the mechanical function of the connector. In particular, soldering with a high step (of for instance more than 200 µm to 300 µm) is conventionally difficult, specifically in a tight cavity. Anisotropic Conductive Film (ACF) placement is also highly difficult for this type of board, when a connector member shall be placed in a preformed cavity. Normally, the substrate below needs to be thin enough to allow the hot plate below to heat up the substrate (like in main camera ACF placement). Additionally the ACF bonding head cannot fit easily into tight cavities.

According to an exemplary embodiment of the invention, resin (in particular prepreg) viscosity and flow control may be implemented to enable to mount or embed a connector member in of a PCB.

More specifically, an exemplary embodiment of the invention provides a PCB board, in which a Btb or ZIP or other type of connector member is placed inside of the PCB stack up with an embedding technology (including surface mounting technology (SMT), Anisotropic Conductive Film (ACF) placement, sequential embedding, cavity embedding, etc.). A corresponding treatment may be adapted so that the connector may be covered by a cured PCB core, and a low-flow dielectric material may be used to laminate the cover core to the main core. These are powerful measures to avoid resin to flow into the connector member body. An advantage of a manufacturing architecture according to an exemplary embodiment of the invention is the opportunity to be able to sink the connector member inside of the PCB stack-up.

In contrast to this, conventional connectors are not feasible to embed, as the risk for resin flowing into the connector body is high, so that the manufactured component carrier may be not sufficiently reliable.

Figure 1 to Figure 4 illustrate different cross-sectional views of structures obtained during carrying out a method of manufacturing a component carrier 100, as shown in Figure 4, according to an exemplary embodiment of the invention.

Referring to **Figure 1****,** an initial procedure of the method of manufacturing component carrier 100 according to the exemplary embodiment of the invention is described. As can be taken from Figure 1, a preformed connector member 102 is mounted on an electrically insulating layer structure 104 and on an electrically conductive layer structure 124. For instance, the connector member 102 may comprise a plastic part formed by molding, wherein an electrically conductive wiring structure may be located in and/or on the plastic part. The connector member 102 may be configured for establishing simultaneously a mechanical connection and an electric connection with a counter connector member 120 (see Figure 4), upon being plugged together by a user. The connector member 102 is mounted on the electrically insulating layer structure 104 in a way to be thereby simultaneously electrically connected to the electrically conductive layer structure 124 of the shown base layer stack composed of electrically insulating layer structure 104 and electrically conductive layer structure 124. For instance, the electrically conductive mounting of the connector member 102 on the described base layer stack can be accomplished by gluing using an Anisotropic Conductive Film (ACF) or an Anisotropic Conductive Paste (ACP). It is alternatively also possible to solder the connector member 102 onto the electrically conductive layer structure 124. The electrically conductive layer structure 124 may be formed partially on and partially in the electrically insulating layer structure 104 by connection and patterning of metal foils (such as copper foils), and by the formation of through holes (such as vias which may be formed by laser drilling or mechanically drilling) with a subsequent filling of these through holes with electrically conductive material (for instance with copper, for example by plating). As can be taken from Figure 1, the connector member 102 is mounted on a substantially planar surface of the electrically insulating layer structure 104, i.e. on a planar surface rather than within a preformed cavity. Such a mounting procedure on a planar support surface is significantly simpler than soldering the connector member 102 within a preformed cavity, as done conventionally.

More precisely, the connector member 102 is mounted on a fully cured core 112 in form of the electrically insulating layer structure 104. The fully cured core 112 may comprise reinforcing less fibers in a matrix of epoxy resin, being already in the C-stage rather than in the A-stage or the B-stage. The fully cured core 112 may have the property that its intrinsic resin does not remelt upon lamination (compare Figure 2), so that the resin of the fully cured core 112 is advantageously incapable of flowing into internal recesses or gaps within the connector member 102 upon lamination. Thus, the mechanical and electric functionality of the connector member 102 is not negatively influenced by the lamination procedure thanks to the provision of the electrically insulating layer structure 104 of already fully cured material.

Summarizing, a PCB core 112 is created. Subsequently, the connector member 102 (which is here embodied as a female part of a two-part connector, but which may alternatively also be a male part of the connector) may be placed on the core 112.

Referring to **Figure 2****,** a further electrically insulating layer structure 110 (arranged on top of the previously described layer stack) as well as yet another electrically insulating layer structure 158 (arranged on the bottom of the layer stack) are interconnected with the connector member 102 on the electrically insulating layer structure 104 by lamination. In other words, the mentioned elements are interconnected with one another by the application of mechanical pressure, optionally supported by heat. As can be taken from Figure 2, the precut further electrically insulating layer structure 110, which is provided with a recess 108, is attached on the electrically insulating layer structure 104 with the connector member 102 being located within the recess 108. Hence, the further electrically insulating layer structure 110 is attached to cover the connector member 102 with a gap in between. According to Figure 2, the connector member 102 is surrounded by the described plurality of electrically insulating layer structures 104, 110 which all comprise resin and is temporarily hermetically encapsulated and located within an internal hollow space.

More specifically, the further electrically insulating layer structure 110 is composed of a further fully cured core 162 and of a no-flow prepreg layer 160 below the further fully cured core 162. As can be taken from Figure 2, the recess 108 is delimited by and between the fully cured core 112, the further fully cured core 162 as well as the no-flow prepreg layer 160. Correspondingly, the other electrically insulating layer structure 158 is composed of yet another fully cured core 166 and of a further no-flow prepreg layer 164 above the other fully cured core 166. In a vertical direction according to Figure 2, a substantially symmetric configuration of the electrically insulating material (compare elements 112, 160, 162, 164, 166) is obtained (compare symmetry axis 168). This suppresses warpage and thermal mismatch. In a stacking direction (i.e. the vertical direction according to Figure 2), the electrically insulating material is formed by an alternating sequence of fully cured cores 112, 162, 166 and no-flow prepreg layers 160, 164 sandwiched in between (the latter serving for interconnecting the various elements during lamination).

During the procedure of fully surrounding the connector member 102 with electrically insulating material, i.e. during lamination, a flow of resin into the connector member 102 is inhibited or is strongly suppressed. This is accomplished by the configuration of elements 112, 162 and 166 of already fully cured material (which may be no more flowable), as well as by the configuration of elements 160, 164 of no-flow prepreg (or alternatively low-flow prepreg). As a consequence, during the surrounding by laminating, a flow of resin into a functional connector structure of the connector member 102 is prevented. Also the provision of the recess 108, which keeps the connector member 102 spaced with regard to adjacent dielectric material, contributes to the protection of the connector member 102 from being contaminated.

As a result of the described manufacturing procedure, a semifinished product 114 according to an exemplary embodiment of the invention is obtained which is composed of the connector member 102, the plurality of electrically insulating layer structures 104, 110, 158 surrounding the connector member 102 so that the connector member 102 is accommodated in a void volume 116 (defined by the recess 108) within the electrically insulating layer structures 104, 110, 158.

In order to obtain the semifinished product 114 shown in Figure 2, the package is laminated together with pre-structured core (compare reference numeral 162) and prestructured prepreg (compare reference numeral 160). By taking this measure, previously not fully cured resin/prepreg material is fully cured. The use of no-flow prepreg avoids or prevents prepreg resin from flowing into the connector area. The cutting of the PCB core (compare reference numeral 162) and of the no-flow prepreg (compare reference numeral 160) for the formation of the recess 108 is performed prior to lamination.

Thus, the preferred combination of the use of recessed dielectric elements as well as dielectric elements which are either fully cured or show substantially no-flow (or only low flow) of resin during lamination results in the reliable protection of the mechanical and electric connector features of the connector member 102 which are kept free of resin material to thereby preserve its mechanical and electric function regardless of the mounting and embedding procedure. However, it should be mentioned that not all of these measures need to be realized in combination in embodiments of the invention. In certain embodiments, it is also possible to substitute the no-flow prepreg by low-flow prepreg or even ordinary prepreg material (in particular when the connector member 102 is sufficiently remote from such ordinary prepreg). Furthermore, it is also possible to omit the recess 108 when surrounding dielectric material which has such a high viscosity that it does not flow into the tiny structures of the connector member 102 during lamination. Furthermore, it is possible to substitute one or more of the cores 112, 162, 166 by low-flow prepreg or no-flow prepreg (or even ordinary prepreg material) so that a coreless component carrier 100 may be manufactured.

Referring to **Figure 3****,** part of the previously encapsulated connector member 102 is exposed to the environment by removing material of the further electrically insulating layer structure 110, for instance by laser cutting (as indicated schematically by reference numeral 170, alternatively by mechanical cutting). As indicated by reference numeral 170, the internal envelope is cut open by laser drilling, depth routing or mechanical drilling. As can be taken from Figure 3, exposing the connector member 102 by removing material of the further electrically insulating layer structure 110 as defined by the control of the cutting procedure results in the formation of a cavity 106 (see Figure 4) which is defined by the electrically insulating layer structure 104 and the further electrically insulating layer structure 110. As a result of this procedure, the connector member 102 is finally located within a cavity 106 formed after mounting the connector member 102 on the electrically insulating layer structure 104. In other words, the cavity 106 is formed on basis of the recess 108 is a direct consequence of the selective material removal procedure.

Referring to **Figure 4****,** a cap area 172 (see Figure 3) defined by the previously described cutting procedure has been removed. The resulting component carrier 100 can be used together with the connector FPC. Thus, the cap area 172 may be removed, and a connector plugging may be carried out.

In the PCB-type component carrier 100 shown in Figure 4, a portion of the connector member 102 remains sunk within the cavity 106 and thus below an upper surface of the further electrically insulating layer structure 110 after the interconnecting and the exposing. This protects the connector member 102 during use and results in a compact design.

A so obtained connection arrangement 124 is composed of the component carrier 100 manufactured as described with the integrated connector member 102. Furthermore, it comprises an electronic device 126 comprising a counter connector member 120 configured for establishing a plug connection with the connector member 102. The connector member 102 is a female connector member 102 configured for cooperating with the counter connector member 120 being a male type connector. The connector member 102 is configured for establishing the electric connection with the counter connector member 120. The electronic device 126 moreover comprises a laminated stack of electrically conductive layer structure 174 (which may be copper foils and copper vias) interconnected with electrically insulating layer structure 176 (for instance made of FR4). Hence, the electronic device 126 may be also a component carrier, in particular a PCB-type component carrier, with integrated connector function. To simplify operation of the electronic device 126 in conjunction with the component carrier 100, it is possible that the electronic device 126 is configured as a flex board.

**Figure 5** illustrates a cross-sectional view of a component carrier 100 according to another exemplary embodiment of the invention. Two particularities shall be described for this embodiment.

Firstly, the component carrier 100 according to Figure 5 has a connector member 102 being sunk within further electrically insulating layer structure 110 in such a way that it is also laterally covered with material of further electrically insulating layer structure 110. This increases compactness of the component carrier 100 and further improves the mechanical protection of the connector member 102.

Secondly, the component carrier 100 of Figure 5 comprises an electronic component 188, which may be a semiconductor chip, embedded in the electrically insulating layer structure 104 and being electrically coupled with the connector member 102 by electrically conductive layer structure 122. Embedding the electronic component 188 in the layer stack of the component carrier 100 may be done by lamination as well. Thus, the embodiment of Figure 5 makes it possible to couple the electronic component 188 with a periphery device (such as electronic device 126) via the connector member 102.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention as claimed even in the case of fundamentally different embodiments.

## Claims

1. A method of manufacturing a component carrier (100), the method comprising:
mounting a connector member (102) on a substantially planar layer structure (104);
interconnecting a further layer structure (110) with the layer structure (104),
wherein, after the mounting, the further layer structure (110), which is provided with a recess (108), is attached on the layer structure (104) with the connector member (102) being at least partially located within the recess (108);
after the interconnecting, exposing at least part of the connector member (102) by removing material of at least one of the layer structures (104, 110); wherein, after the interconnecting and the exposing, at least a portion of the connector member (102) remains sunk within the further layer structure (110).

2. The method according to claim 1, wherein at least one of the layer structures (104, 110) comprises at least one of the group consisting of at least one electrically insulating layer structure and/or at least one electrically conductive layer structure.

3. The method according to claim 1 or 2, wherein the interconnecting comprises laminating the further layer structure (110) with the layer structure (104).

4. The method according to any of claims 1 to 3, wherein the further layer structure (110) is attached to cover the connector member (102) with a gap in between.

5. The method according to any of claims 1 to 4, wherein the removing comprises laser cutting.

## Patentansprüche

1. Ein Verfahren zum Herstellen eines Komponententrägers (100), wobei das Verfahren aufweist:
Montieren eines Konnektorelements (102) auf einer im Wesentlichen planaren Schichtstruktur (104);
Verbinden einer weiteren Schichtstruktur (110) mit der Schichtstruktur (104),
wobei nach dem Montieren die weitere Schichtstruktur (110), die mit einer Aussparung (108) versehen ist, an der Schichtstruktur (104) angebracht wird, wobei das Konnektorelement (102) zumindest teilweise innerhalb der Aussparung (108) angeordnet ist;
nach dem Verbinden, Freilegen zumindest eines Teils des Konnektorelements (102) durch Entfernen von Material von zumindest einer der Schichtstrukturen (104, 110); wobei nach dem Verbinden und dem Freilegen zumindest ein Abschnitt des Konnektorelements (102) innerhalb der weiteren Schichtstruktur (110) vertieft bleibt.

2. Das Verfahren gemäß Anspruch 1, wobei zumindest eine der Schichtstrukturen (104, 110) zumindest eines aus der Gruppe aufweist, die aus zumindest einer elektrisch isolierenden Schichtstruktur und/oder zumindest einer elektrisch leitfähigen Schichtstruktur besteht.

3. Das Verfahren gemäß Anspruch 1 oder 2, wobei das Verbinden ein Laminieren der weiteren Schichtstruktur (110) mit der Schichtstruktur (104) aufweist.

4. Das Verfahren gemäß einem der Ansprüche 1 bis 3, wobei die weitere Schichtstruktur (110) so angebracht wird, dass sie das Konnektorelement (102) mit einer Lücke dazwischen bedeckt.

5. Das Verfahren gemäß einem der Ansprüche 1 bis 4, wobei das Entfernen ein Laserschneiden aufweist.

## Revendications

1. Procédé de fabrication d'un support de composant (100), le procédé comprenant les étapes consistant à :
monter un élément de connexion (102) sur une structure de couche sensiblement plane (104) ;
interconnecter une structure de couche supplémentaire (110) avec la structure de couche (104),
dans lequel, après le montage, la structure de couche supplémentaire (110), qui est pourvue d'un évidement (108), est fixée sur la structure de couche (104), avec l'élément de connexion (102) situé au moins partiellement à l'intérieur de l'évidement (108) ;
après l'interconnexion, exposer au moins une partie de l'élément de connexion (102) en retirant du matériau d'au moins l'une des structures de couche (104, 110) ; dans lequel, après l'interconnexion et l'exposition, au moins une partie de l'élément de connexion (102) reste enfoncée dans la structure de couche supplémentaire (110).

2. Procédé selon la revendication 1, dans lequel au moins une des structures de couche (104, 110) comprend au moins une du groupe constitué d'au moins une structure de couche électriquement isolante et/ou d'au moins une structure de couche électroconductrice.

3. Procédé selon la revendication 1 ou 2, dans lequel l'interconnexion comprend une stratification de la structure de couche supplémentaire (110) avec la structure de couche (104).

4. Procédé selon l'une quelconque des revendications 1 à 3, dans lequel la structure de couche supplémentaire (110) est fixée pour recouvrir l'élément de connexion (102) avec un espace entre ceux-ci.

5. Procédé selon l'une quelconque des revendications 1 à 4, dans lequel le retrait comprend une découpe au laser.
